(19)

Europäisches
Patentamt
European
Patent Office
Office européen
des brevets

(11)   **EP 2 629 425 A1**

(12)   **EUROPEAN PATENT APPLICATION**

(43) Date of publication:
**21.08.2013 Bulletin 2013/34**

(51) Int Cl.:
*H03L 7/24* (2006.01)

(21) Application number: **12156057.7**

(22) Date of filing: **17.02.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **IMEC**
**3001 Leuven (BE)**

• **Vrije Universiteit Brussel**
**1050 Brussel (BE)**

(72) Inventor: **Mangraviti, Giovanni**
**3001 Leuven (BE)**

(74) Representative: **Van Bladel, Marc et al**
**DenK iP bvba**
**Hundelgemsesteenweg 1114**
**9820 Merelbeke (BE)**

(54)   **A robust injection-locked local oscillator**

(57)   The present disclosure relates to an injection-locked local oscillator and a method for calibrating the same. The local oscillator comprising an active circuit-having at least one first resonator connected to the output of the active circuit, and at least one second resonator coupled to said at least one first resonator, thereby forming at least one coupled resonator. In another aspect, the present disclosure relates to a method for calibration the proposed local oscillator, the calibration being a two-step calibration based mainly on power measurement.

Figure 2

EP 2 629 425 A1

## Description

## TECHNICAL FIELD

The present disclosure relates to local oscillators and more specifically, to injection-locked local oscillators.

## DESCRIPTION OF THE RELATED TECHNOLOGY

The demand for realization of a single-chip transceiver for mm-wave applications (e.g. high-datarate wireless 60GHz communication, radar-based sensing at77GHz, 94GHz imaging) having low cost, low area foot print and lowpower consumption is constantly increasing. For wireless transceivers, the local oscillator (LO) system is one of transceiver's power critical blocks.

Currently, mm-wave LO systems are generally based on phase-locked loop (PLL) architectures which operate directly at mm-wave frequencies. In many integrated radios there is a long distance between the PLL and the mixers that are used for upconversion or downconversion. This is especially true in phased-array radios with beamforming implemented in the LO path or at baseband. Consequently, the PLL mm-wave output needs to be heavily buffered to the mixers. Such a mm-wave buffering is generally critical because of power consumption and sensitivity to parasitic capacitance and/or inductance. Further, mm-wave PLLs require mm-wave dividers, which are even more critical than mm-wave buffering. Alternative LO architectures use a low-frequency PLL for injection-locking of the oscillator to one of its harmonics have been proposed.

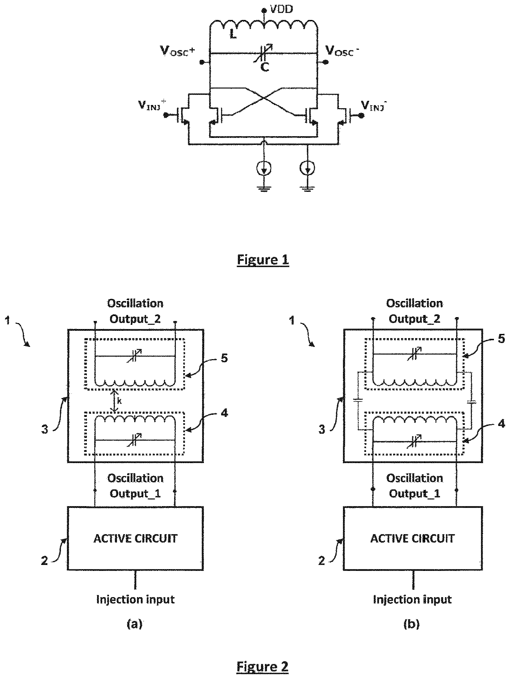

Injection locking of an oscillator is particularly appealing for mm-wave phased-array-antenna transceivers (Figure **1).** This is valid especially for transceiverswith phase shifting at baseband or in the LO path, which require at leasta mm-wave oscillator for each antenna.In this way, the mm-wave oscillators can be positioned close to the mixers while the LO signal that has to be distributed to the different antenna paths is an n-times lower-frequency injection-locking signal instead of a mm-wave LO signal. This leads to lower power consumption and a more robust LO distribution. In addition, injection-locking techniques can achieve comparable or even better phase-noise (PN) performance compared to mm-wave phase-locked loops.

However, the state-of-art injection-locked local oscillator (ILO) architectures for mm-wave CMOS transceivers have generally the disadvantage of being sensitive to disturbances (e.g. random phase changes in the injected signal) and temperature drifts, which bring the oscillator easily out of lockand thus decreasing theirrobustness. The proposed architectures can be split (mainly) into three groups: (1) ILOs with a narrow locking range, (2) ILOs with a wide tuning range, and (3) ILOs with a wide locking range but low quality factor, Q.

The first group of mm-wave injection-locked oscillators offers a narrow locking range (typically, much less than 1GHz). These architectures, however, require either complex control loops or high-resolution frequency tuning to accurately calibrate the n-th harmonic of the injected frequency to fall within the locking range of the oscillator. Further,due to the narrow locking range, the LO could easily go out of lock in presence of disturbances and temperature drifts, which decreasessignificantly the robustness of the oscillator.

The second group proposes ILO architectureswhich offer a wide tuning range, by tuning the locking range within a wide range of frequencies. Again, these architectures are characterized by a narrow locking rangeand require complex calibration circuitry for tuning the centre frequency around which the LO can be injection-locked, and thus suffer from poor robustness.

To improve the robustness of the LO, the third group proposes LO architectures with sufficiently wide locking ranges which also relaxes the requirements on calibration. However, existingsolutions require injection of high-power signals into the oscillator and/or heavily lowered quality factor of the oscillator resonance tank. This results in either large power consumption or a low output signal level, which requires an additional amplifying circuitry which inevitably increases the power consumption and area.

Musa et al, "A low phase noise quadrature injectionlocked frequency synthesizer for mm-wave applications," IEEE JSSC, vol.46, no.11, pp.2635-2649, November 2011, proposes a 60GHz injection locked oscillator with a single resonance tank and a dual injection technique for improving the robustness of the local oscillator. Despite the dual-injection technique, this solution still offers a narrow locking range, i.e. 480MHz at 60GHz, and thus still requiring a complex frequency-measurement-based calibration.

Chan et al, "A 56-65 GHz injection-locked frequency tripler with quadrature outputs in 90-nm CMOS," IEEE JSSC, pp. 2739-2746, Dec. 2008, proposes an injection-locked LO architecture with single resonance tank. A wide locking range (56.5-64.5GHz)is achieved by significantlylowering the quality factor of the resonance tankwith a resistive loading, which leads to low amplitude of the output signal.

It is apparent from the above, that there is a need for robust local oscillator architectures with simplified calibration applicable for low power mm-wave application.

## AIM OF THE PRESENT DISCLOSURE

The present disclosure aims at providing a robust local oscillatorapplicable for low power application and more specifically, a robust injection-locked local oscillatorwith a resonance tank characterised by a wide locking range and a sufficientlyhigh quality factor.

## SUMMARY OF CERTAIN ASPECTS

In one aspect the present disclosure relates to a local oscillator having a frequency range within which said local oscillator is locked, said local oscillator comprising:

- an active circuit, having an input for receiving an input frequency tone for locking said local oscillator to an oscillation frequency, and an output for outputting an output frequency tone, said output frequency tone having an equal or a higher frequency of said input frequency tone, and wherein said output frequency tone is having a frequency equal to said oscillation frequency, and
- at least one first resonator connected to the output of said active circuit, and arranged for receiving said input frequency tone, and at least one second resonator coupled to said at least one first resonator to form at least one coupled resonator, wherein said at least one coupled resonator is arrange to resonate at said oscillation frequency.

In a preferred embodiment, the at least one coupled resonator is coupled magnetically. Alternatively, it can be also coupled capacitively.

In a preferred embodiment, at least one of said first resonator or said second resonator is an LC resonator.

In a preferred embodiment, the LC resonator comprises a variable capacitor for adjusting the oscillation frequency of the local oscillator.

The proposed local oscillator is characterized by (i) a wide frequency range within which the local oscillator can be locked and (ii) a sufficiently high quality factor. The wide locking range is achieved by designing the local oscillator to comprise at least one coupled resonator with an equivalent impedance phase characterized by a wide flat region positioned around zero degrees. Advantageously, the power of its output frequency tone of the proposed local oscillator does not suffer from high penalty.

In another preferred embodiment, said frequency range within which said local oscillator can be locked is at least in part set by adjusting the coupling factor of said at least one coupled resonator.

In another preferred embodiment, said locking frequency range is further adjusted by setting at least one parameter of said at least one coupled resonator.

In an preferred embodiment, said at least one coupled resonator has an equivalent impedance phase with a flat region.

In an advantageous embodiment, the active circuitry of the local oscillator is differential. As the person skilled in the art will readily recognize, the proposed local oscillator can be embedded in other oscillator implementations, for example, in differential and/or in quadrature injection-locked local oscillators.

In another aspect the present disclosure relates to a method for calibrating a local oscillator, the method comprising the steps of:

- selecting a frequency range within which said local oscillator is to be locked by adjusting at least one parameter of said at least one first resonator, thereby shifting the center of said frequency range from one frequency to another frequency, wherein the equivalent impedance phase of said at least one coupled resonator is characterized with a flat region within said frequency region, and
- maximizing said frequency range, by adjusting at least one parameter of said at least one second resonator, thereby positioning said flat region of the equivalent impedance phase at zero degrees,

wherein the width of said frequency region is at least in part defined by the coupling factor of said at least one coupled resonator.

In a preferred embodiment the locking frequency range is selected by adjusting the capacitance of the at least one first resonator.

In a preferred embodiment, the locking frequency range is maximized by adjusting the capacitance of the at least one second resonator.

Indeed, by selecting a coupling factor such that the equivalent impedance phase of the coupled resonator is characterized with a flat region, and by further tuning some of the parameters defining the equivalent resonant frequency of the local oscillator resonator, the resonator can be tuned to provide a wide locking frequency range.

In a preferred embodiment the maximizing of the width of said frequency range is based on measuring the output power of said local oscillator oscillation frequency.

Advantageously, the equivalent impedance magnitude of the local oscillator resonator is characterized by a relative minimum, which allows the second step of the calibration to be performed by measuring the power output frequency tone.

## BRIEF DESCRIPTION OF THE DRAWINGS

Presently preferred embodiments are described below in conjunction with the appended figures and figures description, wherein:

Figure 1 illustrates an injection-locked local oscillator with a single resonator tank.

Figure 2 illustrates a block scheme of an injection-locked local oscillator according to an embodiment of the present disclosure.

Figure 3 illustrates an injection-locked local oscillator schematic according to one embodiment of the present disclosure.

Figure 4 illustrates an injection-locked local oscillator schematic according to another embodiment of the present disclosure.

Figure 5 illustrates the equivalent impedance phase and magnitude observed at the primary circuit of a coupled resonance tank for different values of the coupling factor K.

Figure 6 illustrates the impedance phase of the coupled resonator of the present disclosure in comparison to the state-of-the-art approaches.

Figure 7 illustrates the impedance magnitude of the coupled resonator of the present disclosure in comparison to the state-of-the-art approaches.

Figure 8 illustrates the impedance phase and magnitude of the proposed coupled resonator for different $C_2/C_1$ ratios.

Figure 9 illustrates the coarse tuning (first step of the calibration) of the proposed coupled resonator.

Figure 10 illustrates the fine tuning (second step of the calibration) of the coupled resonator.

## DETAILED DESCRIPTION OF CERTAIN ILLUSTRATIVE EMBODIMENTS

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting of only components A and B. It means that with respect to the present invention, the only relevant components of the device are A and B.

For wireless communication at data rates above 1Gbit/s a frequency band of 7GHz is allocated around 60GHz. In this frequency band several applications are targeted with mass-market potential. Wireless consumer products require cheap implementation technologies in combination with low power consumption. Downscaled digital CMOS, which is cheap for large-volume products, is capable to handle 60GHz signals with baseband bandwidths around 1GHz.

The robustness of local oscillator (LO) systems based on injection locking is improved by increasing their locking range. The robustness defines the sensitivity of the local oscillator to disturbances (e.g. random phase changes in the injected signal) and temperature drifts, which cause the oscillator to easily go out of lock. In other words, the more robust the oscillator, the less sensitive it is to disturbances. Further, improved local oscillator robustness lessens the constraints on the oscillator's calibration, i.e. no complex tuning is needed before the operation of the LO system.

However, designing a LO resonant tank with a wide locking range represents a design challenge. Injection-locked LO is one of the main applications of injection locking in the field of RF IC design. Injection-locking scheme implies that the oscillator is locked to the n-th harmonic of the injected signal (i.e. n≥1). For n>1, the n-th harmonic of the injected signal is usually generated thanks to the nonlinear behaviour of MOS transistors in the active core of the oscillator. Since such n-th harmonics are usually low in power, the injection-locking condition stays valid only over a narrow frequency range, which means that the locking range is narrow. The injection-locking condition is as follows:

$$I_{INJ} \geq \frac{4}{\pi} I \sin \alpha \qquad (1)$$

, wherein $I_{INJ}$ is the current injected in the oscillator, $4I/\pi$ is the first harmonic of the oscillation current when the oscillator is free-running, and $\alpha$ is the phase of the impedance of the resonant tank.

The locking range of an injection-locked oscillator can be defined as the frequency range over which the locking condition (Equation 1) remains valid. From a design point of view, Equation 1 shows that the injection-locking range can be improved by:

a) injecting signals with a sufficient amount of power, i.e. $I_{INJ}$ with a high amplitude or
b) designing a resonance tank with small impedance phase, i.e. $\alpha$ is close to zero degrees over a wide frequency range.

The first condition requires a power consumption which is unacceptable for low-power applications,

while the second condition is generally implemented by designing the resonance tank with a low quality factor (Q). Lowering the quality factor, implies a wide locking range but also a weak output voltage of the injection-locked oscillator, thus requiring more power for output buffering. Hence, designing an injection-locked oscillator with wide locking range and relatively high quality factor is a design challenge.

In one embodiment, the present disclosure describes an injection-locked local oscillator (1) with an active circuit (2) and a coupled resonator (3), characterized by an impedance phase plateau around zero degrees and a relatively high quality factor **(Figure 2)**. A coupled resonator with a wide locking range may be designed with different types of resonator tanks (e.g. LC tanks) which may be coupled in different manners, e.g. magnetically or electrically (capacitively) coupled as shown in **Figure 2(a)** and **Figure 2(b),** respectively. For simplicity the coupled resonator is shown as two LC resonators, however, each resonator at the primary circuit (4) and/or at the secondary circuit (5) may consist of multiple of resonators.

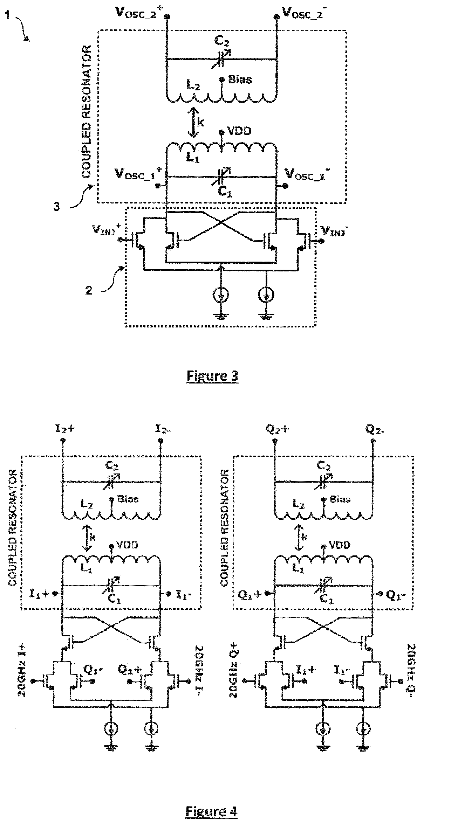

**Figure 3** shows an example of a possible injection-locked LO architecture (1), consisting of an active circuit (2) and a coupled resonator (3). The active circuit consists of a first pair of NMOS transistors through which an external signal ($V_{INJ}$ in **Figure 2**) is injected into the oscillator and a second pair of cross-coupled NMOS transistors. In this architecture, the coupled resonator (3) comprises two magnetically-coupled LC tanks forming a transformer, wherein the first resonator tank (4) connected to the active circuit (2) is formed by $L_1$ and $C_1$, and the second resonator (5) by $L_2$ and $C_2$. For this example architecture, $C_1$ and $C_2$ are variable capacitors and can be used for calibration of the free-running frequency of the coupled resonator (3), as will be explained below. As mentioned above, different type of resonators coupled using different schemes are also possible. The output of the local oscillator can be taken at the primary circuit (i.e. at nodes $V_{OSC\_1}$+ and $V_{OSC\_1}$-) or at the secondary circuit (i.e. at nodes $V_{OSC\_2}$+ and $V_{OSC\_2}$-) of the coupled resonator.

Though, **Figure 3** shows a differential injection-locked oscillator, the skilled person in the art will immediately recognize that the same topology can be generalized for single-ended oscillators.

Further, the skilled person will also recognize that the proposed injection-locked LO architecture can also be used in various injection-locked architectures, for example, sub-harmonic injection-locked quadrature voltage-controlled oscillator (SHIL-QVCO) architectures as shown in **Figure 4,** where a 20GHz quadrature signal is injected to lock the SHIL-QVCO at 60GHz oscillation frequency. More specifically, this SHIL-QVCO consists of two coupled voltage-controlled oscillators (VCO). Similarly to the architecture of **Figure 3,** each of these two VCOs consists of an active circuit and a coupled resonator. The active circuit consists of a first pair of NMOS transistors through which an external 20GHz quadrature signal (20GHz I+, 20GHz I-, and, 20GHz Q+, 20GHz Q- in **Figure 4**) is injected into the oscillator, a second pair of NMOS transistors through which the two VCOs are coupled to each other ($I_1$+, $I_1$-, and, $Q_1$+, $Q_1$-), and a third pair of cross-coupled NMOS transistors. The same coupled resonator as in **Figure 3,** comprising two magnetically-coupled LC tanks forming a transformer is used, wherein the first resonator tank connected to the active circuit is formed by $L_1$ and $C_1$, and the second resonator by $L_2$ and $C_2$. In particular, $C_1$ and $C_2$ are variable capacitors and can be used for calibration of the equivalent impedance phase of the coupled resonator, as explained further below. The output of this SHIL-QVCO can be taken at the primary circuit of the coupled resonators (i.e. at nodes $I_1$+, $I_1$-, $Q_1$+, $Q_1$- in **Figure 4**) or at the secondary (i.e. at nodes $I_2$+, $I_2$-, $Q_2$+, $Q_2$- in **Figure 4**).

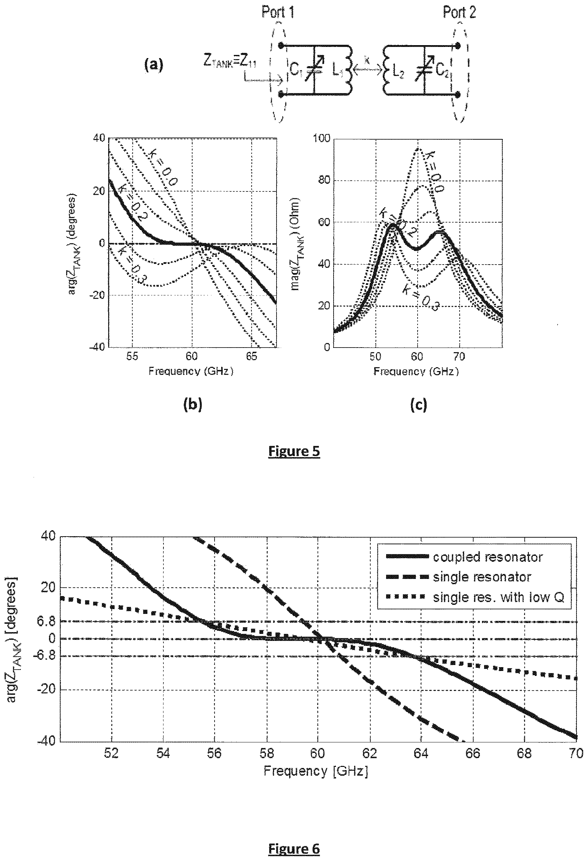

The properties of a coupled resonator tank are explained by way of example. **Figure 5** shows the magnitude and phase of the impedance of a coupled resonator with respect to different values of coupling factor (k). More specifically, this impedance is the equivalent impedance seen at the primary of the coupled resonance tank (i.e. $Z_{11}$). In other words, if we consider the coupled resonator as a two-port network, as shown in **Figure 5(a),** with Port 1 at the primary circuit and Port 2 at the secondary circuit, the impedance here discussed would be the so-called $Z_{11}$. **Figure 5(b),** shows that a coupling factor of k = 0.2 provides a phase plateau of approximately 5 GHz covering most of the complete 60GHz communication band. As can be seen in **Figure 5(c),** some penalty with respect to the impedance magnitude is observed if compared to a single-resonator tank (i.e. k = 0.0). More specifically, the coupled resonator with a coupling factor of k = 0.2 has about 2 times lower impedance magnitude than the single resonator (k = 0.0). This penalty implies a lower voltage oscillation amplitude in the oscillator. However, as it will become apparent below, this penalty is significantly lower in comparison to a single resonator with low Q factor.

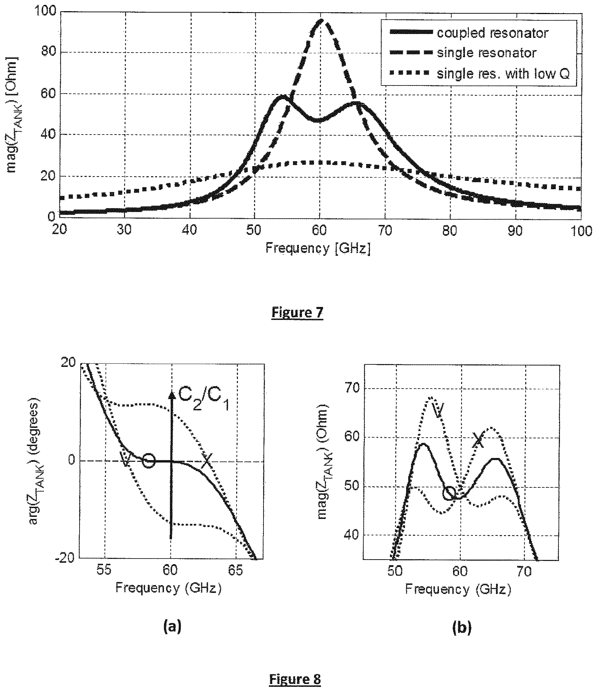

A comparison to the state-of-art approaches can be performed by observing the phase and the magnitude of the resonance tank impedance (the phase and magnitude of $Z_{11}$). Generally speaking, the impedance phase influences the locking range (see Equation 1) while the impedance magnitude influences the magnitude of the output voltage oscillation (i.e. the higher impedance magnitude, the higher voltage oscillation magnitude). **Figure 6** and **Figure 7** depict a comparison between the above-mentioned state-of-art approaches and the approach proposed in the present disclosure, i.e.

i) an injection-locked oscillator with a single resonator;

ii) an injection-locked oscillator with a single resonator with low Q factor;

iii) an injection-locked oscillator witha coupled-resonator, as proposed in the present disclosure.

For a fair comparison the single-resonance tank has
been modelled with the same Q factor as the coupled-
resonance tank, while the single-resonance tank with
lowered Q factor (i.e. a single resonator with a resistive
loading) has been modelled to have the same locking
range of the proposed coupled resonator. In particular,
**Figure 6** shows the impedance phaseof the resonance
tank, i.e. $\arg(Z_{11}){\equiv}\arg(Z_{TANK})$, and **Figure 7** shows its
impedance magnitude, i.e. $\mathrm{mag}(Z_{11}){\equiv}\mathrm{mag}(Z_{TANK})$.

Because injection locking occurs within a frequency range where the impedance phase of the LO is
close to zero degrees - between -6.8° and +6.8° in **Figure
6,**a conventional oscillator with a single-resonance tank
must be calibrated such that its free-running oscillation
frequency falls very close to the injected frequency - within 59-61 GHz in **Figure 6.** In other words, this system
exhibits a narrow locking range. Such calibration is complex and it requires a fine frequency sensing.

In contrary, oscillators with a single-resonance
tank with low Q factor are characterized by a wide locking
range. Hence,no complex calibrationis required asthe
locking range of the free-running oscillation is wide - locking range of56-64 GHz in **Figures6.** However, as explained above, these oscillators have a major drawback
of a heavy penalty in output power (i.e.the magnitude of
the output voltage oscillation is lowered). **Figure 7** shows
that their impedance magnitude, i.e. $\mathrm{mag}(Z_{TANK}) \approx 20\Omega$,
is about 4 times lowerthan a conventional oscillator with
a narrow locking range,i.e. $\mathrm{mag}(Z_{TANK}) \approx 95\Omega$.

The proposed oscillator with a coupled-resonance tankdoes not require a complex calibration, thanks
to its wide locking range (i.e. 56-64GHz as shown in **Figure 6).** Compared to a conventional approach with a single-resonance tank and low Q, the proposed LO offers
about two times higher output power, i.e. $\mathrm{mag}(Z_{TANK}) \approx
55\Omega$.

Depending on the type of coupled resonator,
somecalibration isstill needed to set the resonance tank
impedance phase plateau around zero degrees.For the
proposed coupled resonator of **Figure 2,** thecalibration
requires that the self-resonance frequencies of the first
resonator (2) and the second resonator (3)- defined as
$\omega_1$ and $\omega_2$ respectively - are tuned such that Equation (2)
is satisfied.

$$\frac{\omega_2}{\omega_1} \approx \sqrt{\left(1 - k^2\right)} \qquad (2)$$

In another embodiment, the present disclosure proposes
a method for calibrating the proposed injection-locked
oscillator with a coupled resonator. A two-step calibration
is proposed, assuming that the self-resonance frequency of each of the two resonators can be tuned. Firstly, a
*coarse calibration* (i.e. low-resolution tuning) of the self-
resonance frequency of the first resonator ($\omega_1$) is per-
formed in order to select an operating frequency band
for the oscillator. Frequency sensing may be required
but, since this step requires only a coarse tuning, such
sensing is much simpler in comparison to the fine frequency sensing required for tuning narrow-locking-range
oscillators. Once $\omega_1$ is fixed, a *fine calibration*(*i.e.* high-
resolution tuning) of the self-resonance frequency of the
second resonator ($\omega_2$) is performed in order to set the
phase plateau of $Z_{TANK}$aroundzero degrees. More spe-
cifically, $\omega_2$ must be set so that Equation 2 is fulfilled.Ad-
vantageously, thistuning of $\omega_2$requires only the monitor-
ing (measuring)of the output power of the oscillator, in
other words, detecting the relative minimum of the impedance magnitude.

Considering the coupled resonator shown in
**Figure 3,** equation (2) can be written as follows:

$$C_1/C_2 \approx L_2/L_1 \cdot (1 - k^2) \qquad (3)$$

One way to adjust the self-resonance frequency of this
coupled resonators is by, for example, adjusting the var-
iable capacitors $C_1$ and $C_2$ until the ratio $C_2/C_1$ satisfies
Equation 3.

**Figure8** illustrates in details the specifics of the
calibrationfor the coupled resonator shown in **Figure 3,**
wherein **Figure 8(a)** shows the effect of changing the
ratio $C_2/C_1$ with respect to the position of the impedance
phase plateau, while **Figure 8(b)** the corresponding impedance magnitude which defines the output power of
the (voltage) oscillation signal. Adjustingthe variable ca-
pacitors $C_1$ and $C_2$ reflects in shifting thephase plateau
of the free-running oscillation ($Z_{TANK}$)along the y-axis.Three examples for phase plateau positioned (a)
above zero degrees, (b) at zero degrees and (c) below
zero degrees are illustrated by the points 'V', 'O' and 'X'
respectively. For the setting corresponding to Point 'V',
the locking range is narrow as the impedance phase
curve around zero degrees has a steep slope (see **Figure
8(a)),** and the output power of the oscillation signal is
high, corresponding to the output power of a single res-
onator (i.e. $\mathrm{mag}(Z_{TANK}){\approx}65\Omega$ in**Figure 8(b)).** Similar observation can be made for the setting corresponding to
Point 'X'. Point 'O', however, shows that when the phase
plateau positioned at zero degrees,the free-running oscillation phase has a relative minimum (as $\mathrm{mag}(Z_{TANK})$
has a relative minimum). This relative minimum, which
is observed in the impedance magnitude, is marked by-
Point 'O' in**Figure 8(b).**In other words, by modifying the
$C_2/C_1$ratio (or $\omega_2/\omega_1$ratio), the free-running oscillation
amplitude encounters a relative minimum as the phase
plateau reaches zero degrees. Advantageously, this allows the system to be calibrated by detecting the relative minimum of the oscillation amplitude. Such a calibration is thus based on power measurement and not on a frequency measurement, while oscillators with a narrow-locking range do require a high-resolution RF-frequency measurement.

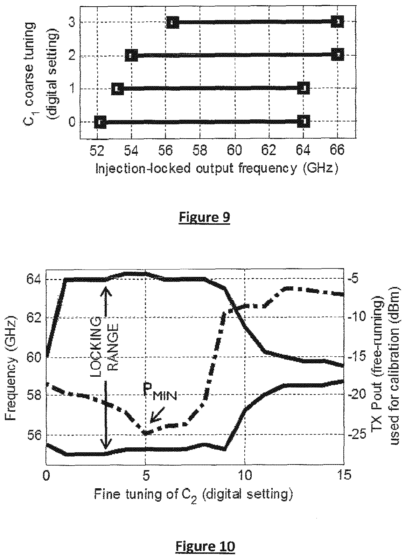

**Figures 9 and 10** illustrate more in details the two-step calibration approach for the example architecture of mm-wave SHIL-QVCO shown in **Figure 4.** In particular, **Figures 9 and 10** show some measurements performed on an implementation in a 40nm CMOS technology. Firstly, a *coarse calibration* is performed for selecting an operating frequency band for the oscillator by coarsely tuning the value of capacitor $C_1$, as shown in **Figure 9.** For the course calibration only a 2-bit resolution for the capacitor $C_1$ is sufficient for tuning the locking range over a wide band, i.e. 52 - 66GHz. In the figure, four different operating frequency bands are shown, i.e. 52-64GHz, 53-64GHz, 54-66GHz and 56.5-66GHz. Once the value of $C_1$ is defined, a *fine calibration* is performed for setting the phase plateau of the impedance of the resonant tank at zero degrees by tuning capacitor $C_2$. **Figure 10** shows the effect of the fine tuning $C_2$ on the measured oscillation power (shown as dashed-dotted line) and the corresponding locking range (shown as a distance between the solid lines). The fine calibration is performed when the oscillator is free-running, i.e. when no signal is injected. Under such a condition, the relative minimum in power can be easily detected. A relative minimum in the oscillation power (indicated by $P_{MIN}$ in **Figure 10**) is detected when $C_2$ is set to 5. This also corresponds to a maximum locking range, i.e. a locking range of more than 8GHz.

In summary, the proposed injection-locked local oscillator with a coupled resonator offers a wide locking range with a relatively high quality factor. The proposed architecture is suitable for low-power applications as first, it does not require powerful signal injection, and second, it does not require power-expensive amplification circuit for output buffering. Furthermore, the architecture allows for simple calibration mainly based on RF power measurement, which is significantly simpler than an accurate RF frequency measurement.

## Claims

1. A local oscillator (1) having a frequency range within which said local oscillator is locked, said local oscillator comprising:

   - An active circuit (2), having an input for receiving an input frequency tone for locking said local oscillator to an oscillation frequency, and an output for outputting an output frequency tone, said output frequency tone having an equal or a higher frequency of said input frequency tone, and wherein said output frequency tone is having a frequency equal to said oscillation frequency, and

   - At least one first resonator (4) connected to the output of said active circuit (2) and arranged for receiving said input frequency tone, and at least one second resonator (5) coupled to said at least one first resonator (5) to form at least one coupled resonator (3), wherein said at least one coupled resonator (3) is arrange to resonate at said oscillation frequency.

2. The local oscillator as in Claim 1, wherein said at least one coupled resonator (3) is coupled magnetically.

3. The local oscillator as in Claim 1, wherein said at least one coupled resonator (3) is coupled capacitively.

4. The local oscillator as in any of the previous claims, wherein at least one of said first resonator (4) or said second resonator (5) is an LC resonator.

5. The local oscillator as in Claim 4, wherein said LC resonator, comprises a variable capacitor (C1; C2) for adjusting said oscillation frequency.

6. The local oscillator as in any of the previous claims, wherein said frequency range is at least in part set by adjusting the coupling factor of said at least one coupled resonator (3).

7. The local oscillator as in Claim 6, wherein said frequency range is further adjusted by setting at least one parameter (C1; C2) of said at least one coupled resonator (3).

8. The local oscillator as in any of the previous claims, wherein said at least one coupled resonator (3) has an equivalent impedance phase with a flat region.

9. The local oscillator as in any of the previous claims, wherein the active circuit (2) is differential.

10. A method for calibrating a local oscillator as in Claim 1, the method comprising the steps of:

    - Selecting a frequency range within which said local oscillator (1) is to be locked by adjusting at least one parameter of said at least one first resonator (4), thereby shifting the center of said frequency range from one frequency to another frequency, wherein the equivalent impedance phase of said at least one coupled resonator (3) is characterized with a flat region within said frequency region, and

    - Maximizing said frequency range, by adjusting at least one parameter of said at least one second resonator (5), thereby positioning said flat regionof the equivalent impedance phase at zero degrees,

wherein the width of said frequency region is at least in partdefined by the coupling factor of said at least one coupled resonator (3).

11. The method for calibrating as in Claim 10, wherein said at least one parameter of said at least one first resonator (4) is the capacitance.

12. The method for calibrating as in Claim 10, wherein said at least one parameter of said at least one second resonator (5) is the capacitance.

13. The method for calibrating as in Claim 10, wherein the positioning of said flat region is based on measuring the output power of said oscillation frequency.

Figure 1

Figure 2

**Figure 3**

**Figure 4**

**Figure 5**

**Figure 6**

**Figure 7**

(a)

(b)

**Figure 8**

Figure 9

Figure 10

Europäisches
Patentamt

European
Patent Office

Office européen
des brevets

# EUROPEAN SEARCH REPORT

Application Number

EP 12 15 6057

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BIRKELAND J ET AL: "TWO-PORT FET OSCILLATORS WITH APPLICATIONS TO ACTIVE ARRAYS", IEEE MICROWAVE AND GUIDED WAVE LETTERS, IEEE INC, NEW YORK, US, vol. 1, no. 5, 1 May 1991 (1991-05-01), pages 112-113, XP000206338, ISSN: 1051-8207, DOI: 10.1109/75.89080 | 1,6-8, 10-13 | INV. H03L7/24 |
| Y | * the whole document * | 2-5,9 | |
| Y | US 6 175 285 B1 (GABARA THADDEUS JOHN [US]) 16 January 2001 (2001-01-16) * abstract; figures 3-7 * | 2-5,9 | |
| X | GB 2 198 302 A (GEN ELECTRIC CO PLC GEN ELECTRIC PLC [GB]) 8 June 1988 (1988-06-08) * the whole document * | 1,10-13 | |

TECHNICAL FIELDS SEARCHED (IPC)

H03L
H03B

The present search report has been drawn up for all claims

| Place of search | Date of completion of the search | Examiner |
|---|---|---|
| The Hague | 27 July 2012 | Beasley-Suffolk, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 12 15 6057

This annex lists the patent family members relating to the patent documents cited in  the above-mentioned European search report.
The members are as contained in the European Patent Office EDP file on
The European Patent Office is in no way liable for these particulars which are merely given for the purpose of information.

27-07-2012

| Patent document cited in search report | | Publication date | Patent family member(s) | Publication date |
|---|---|---|---|---|
| US 6175285 | B1 | 16-01-2001 | NONE | |
| GB 2198302 | A | 08-06-1988 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MUSA et al.** A low phase noise quadrature injection-locked frequency synthesizer for mm-wave applications. *IEEE JSSC,* November 2011, vol. 46 (11), 2635-2649

- **CHAN et al.** A 56-65 GHz injection-locked frequency tripler with quadrature outputs in 90-nm CMOS. *IEEE JSSC,* December 2008, 2739-2746